# EUROPÄISCHE PATENTSCHRIFT

(11) **EP 1 800 403 B1**
(45) Veröffentlichungstag und Bekanntmachung des Hinweises auf die Patenterteilung: **18.01.2012**
(21) Anmeldenummer: 05786735.0
(22) Anmeldetag: 04.10.2005
(51) Int. Cl.: H03K 17/785

(54) **SIGNALÜBERTRAGUNGSSYSTEM ZUR ANSTEUERUNG EINES LEISTUNGSHALBLEITERSCHALTERS SOWIE EIN UMRICHTER MIT EINEM SOLCHEN SIGNALÜBERTRAGUNGSSYSTEM**
SIGNAL TRANSMISSION SYSTEM FOR ACTIVATING A POWER SEMICONDUCTOR SWITCH, AND A CONVERTER EQUIPPED WITH A SIGNAL TRANSMISSION SYSTEM OF THIS TYPE
SYSTEME DE TRANSMISSION DE SIGNAUX SERVANT A PILOTER AU MOINS UN COMMUTATEUR STATIQUE DE PUISSANCE ET CONVERTISSEUR MUNI D'UN TEL SYSTEME DE TRANSMISSION DE SIGNAUX

(30) Priorität: 15.10.2004 EP 04405648
(43) Veröffentlichungstag der Anmeldung: 27.06.2007
(73) Patentinhaber: ABB RESEARCH LTD., 8050 Zürich (CH)
(72) Erfinder: CELANOVIC, Nikola, CH-5400 Baden (CH); MEYSENC, Luc, F-38120 Le Fontanil (FR); MAZUR, Michael, CH-8037 Zürich (CH); RUDOLF, Paul, CH-5234 Villigen (CH)
(74) Vertreter: ABB Patent Attorneys
(86) Internationale Anmeldenummer: PCT/CH2005/000574
(87) Internationale Veröffentlichungsnummer: WO 2006/039823

(56) Entgegenhaltungen:
- EP-A- 0 980 142
- EP-A- 0 996 227
- US-A- 5 210 479
- US-A- 5 383 082

## Beschreibung

### Technisches Gebiet

Die Erfindung bezieht sich auf das Gebiet der Leistungselektronik. Sie betrifft ein Signalübertragungssystem zur Ansteuerung von mindestens einem Leistungshalbleiterschalter und einen Umrichter gemäss den Oberbegriffen der unabhängigen Ansprüche.

### Stand der Technik

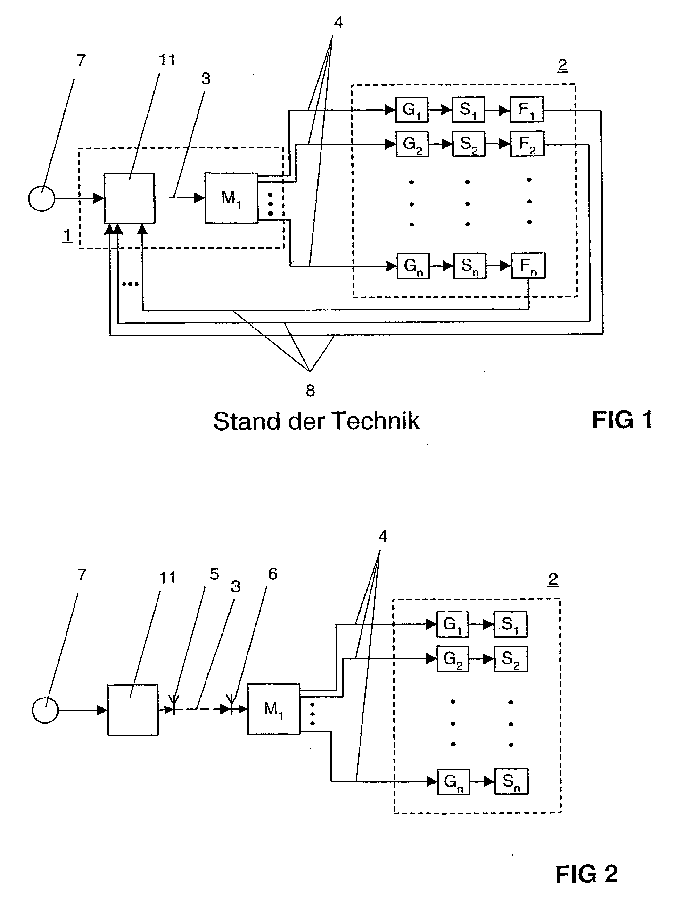

FIG 1 zeigt ein herkömmliches Signalübertragungssystem für einen Umrichter. Gemäss FIG 1 umfasst eine Ansteuereinrichtung 1 einen Regler 11 und einen Modulator M₁. Ein erster Übertragungsweg 3 befindet sich zwischen dem Regler 11 und dem Modulator M₁ und umfasst ein Kabel sowie Lichtwellensender wie Dioden zum Senden und Lichtwellenempfänger wie Dioden zum Empfangen von Signalen. Eine leistungselektronische Schaltung 2 umfasst Ansteuerelektrodentreiberstufen G₁, G₂,..., Gₙ , welche je mit einem Leistungshalbleiterschalter S₁, S₂, ..., Sₙ verbunden sind. Zwischen dem Modulator M₁ und jeder Ansteuerelektrodentreiberstufe G₁, G₂, ..., Gₙ befindet sich jeweils ein zweiter Übertragungsweg 4, welcher jeweils einen Lichtwellenleiter wie ein Glasfaserkabel oder ein Fiberoptik-Kabel aus Kunststoff umfasst sowie Dioden zum Senden und Empfangen von Signalen. Die zweiten Übertragungswege 4 sind dabei in einer Sternstruktur angeordnet.

In der leistungselektronischen Schaltung 2 können auch Überwachungssensoren F₁, F₂, ..., Fₙ vorgesehen sein zur Messung der Zustände einzelner Komponenten der leistungselektronischen Schaltung 2 oder der gesamten leistungselektronischen Schaltung 2. Zwischen den Überwachungssensoren F₁, F₂, ..., Fₙ und dem Regler 11 befindet sich jeweils ein dritter Übertragungsweg 8, welcher jeweils einen Lichtwellenleiter sowie Dioden zum Senden und Empfangen von Signalen umfasst.

Ein Referenzwert 7 wird zum Regler 11 gesendet. Aus dem Referenzwert 7 wird in dem Regler 11 ein Regelsignal ermittelt. Vom Regler 11 aus wird das Regelsignal über den ersten Übertragungsweg 3 an den Modulator M₁ gesendet. In dem Modulator M₁ wird aus dem Regelsignal der Tastgrad für jeden einzelnen Schalter S₁, S₂, ..., Sₙ ermittelt. Der Tastgrad entspricht dem Zeitabstand zwischen zwei Schaltvorgängen eines Schalters S₁, S₂, ..., Sₙ, wobei jeder Schalter S₁, S₂, ..., Sₙ nur zwischen zwei Schaltzuständen - eingeschaltet und ausgeschaltet - wechseln kann. Von dem Modulator M₁ wird mittels Diode über jeweils einen zweiten Übertragungsweg 4 je ein Ansteuersignal mit dem Befehl, den zugehörigen Schalter S₁, S₂, ..., Sₙ einzuschalten oder auszuschalten, an jede einzelne Ansteuerelektrodentreiberstufe G₁, G₂,..., Gₙ übertragen und dort mittels Dioden empfangen. In den Überwachungssensoren F₁, F₂, ..., Fₙ werden die Zustände einzelner Komponenten der leistungselektronischen Schaltung oder der gesamten leistungselektronischen Schaltung gemessen. Die gemessenen Werte werden mittels Dioden als Rückmeldesignale an den Modulator M₁ gesendet und dort mittels Dioden empfangen und in der Ermittlung des Tastgrades der Schalter S₁, S₂, ..., Sₙ berücksichtigt. Bei einer solchen Sternstruktur der zweiten Übertragungswege 4 ist für jeden Umrichter eine Schnittstelle erforderlich, die genau auf die Anzahl der im Umrichter befindlichen Schalter ausgelegt ist. Wenn der Umrichter auf eine andere Anzahl von Schaltern gewechselt werden soll, ist die Erstellung einer neuen Schnittstelle erforderlich.

Eine andere Art zur Anordnung der Schalter ist eine Ringstruktur, bei der beginnend beim Modulator jeder Schalter über einen Lichtwellenleiter mit dem nächsten Schalter in Reihe verbunden ist. Eine solche Anordnung ist einfach und kostengünstig aufzubauen, ist jedoch sehr fehleranfällig, weil der Ausfall eines einzelnen Schalters oder eine Beschädigung in einem der Lichtwellenleiter oder der Anschlüsse der Lichtwellenleiter zum Ausfall der gesamten Ringstruktur führt. Ein weiteres Problem ist die Zeitverzögerung, mit der sich das Signal über die Ringstruktur ausbreitet und durch die jeder Schalter mit einer Zeitverzögerung im Vergleich zum zuvor geschalteten Schalter geschaltet wird.

Problematisch bei den vorstehend genannten Übertragungswegen insbesondere mit Lichtwellenleitern ist, dass sie unzuverlässig sind. Beim Ausfall einer Diode wird kein Signal mehr übertragen. Es ist ausserdem ein sehr guter Übergang zwischen den Lichtwellenleitern und Dioden notwendig, um die Signale zuverlässig übertragen zu können, und dieser Übergang ist störanfällig. Zudem sind Lichtwellenleiter und Kabel mechanisch empfindlich und empfindlich gegenüber Verschmutzung. Daher ist eine solche Verkabelung besonders in rauher Umgebung unzuverlässig. Die Verkabelung ist bei der Herstellung und im Falle einer Reparatur aufwendig und benötigt zudem viel Platz.

US 5,210,479 beschreibt eine Ansteuerungseinheit für einen IGBT, welche den Zustand des IGBTs erkennt und Signale zur Steuerung des IGBTs über einen Leiter sendet. Im Falle eines Überstromsignals am IGBT wird ein Rückmeldesignal erzeugt, welches von einer mit dem IGBT verbundenen licht-emittierenden Diode zu einem Phototransistor in der Ansteuerungseinheit gesendet wird, und aufgrund dessen der IGBT wieder auf einen vorgegebenen Wert innerhalb der SOA ("safe operating area" geregelt wird.

US 5,383,082 beschreibt ein System zum Schutz eines Leistungshalbleiterschalters wie IGBT, Leistungs-MOSFET oder Bipolartransistor vor einer Überstrom. Von einem mit einer Steuerungseinheit verbundenen ersten LED wird ein Ansteuersignal zu einem ersten Phototransistor übertragen, welcher wiederum mit dem IGBT verbunden ist. Ein zweites LED ist zwischen dem Gate des IGBTs und einer Spannungsversorgung für die Gatespannung angeordnet. Im Falle eines Überstroms sendet der zweite LED ein Signal an einen zweiten, mit der Ansteuerungseinheit verbundenen Phototransistor. Mit dem zweiten LED wird einerseits die Gatespannung begrenzt und andererseits ein Überstromsignal an die Ansteuereinheit gesendet, welches zur Regelung des IGBTs benutzt werden kann. Mit dieser Anordnung ist die Ansteuereinheit galvanisch von dem IGBT getrennt.

### Darstellung der Erfindung

Aufgabe der Erfindung ist daher, ein Signalübertragungssystem zur Ansteuerung von mindestens einem Leistungshalbleiterschalter mit verbesserter Zuverlässigkeit zu schaffen. Ferner ist es die Aufgabe der Erfindung, einen Umrichter mit verbesserter Zuverlässigkeit anzugeben.

Diese Aufgaben werden erfindungsgemäss durch die Merkmale der unabhängigen Patentansprüche 1, 6 und 10 gelöst.

Das erfindungsgemässe Signalübertragungssystem dient zur Ansteuerung mindestens eines Leistungshalbleiterschalters einer leistungselektronischen Schaltung von einem Regler aus, wobei jeder Leistungshalbleiterschalter mit jeweils einer Ansteuerelektrodentreiberstufe verbunden ist. Von dem Regler aus ist mindestens ein Regelsignal an mindestens einen Modulator über mindestens einen ersten Übertragungsweg übertragbar. Über je einen zweiten Übertragungsweg ist mindestens ein Ansteuersignal von dem mindestens einen Modulator an jede der Ansteuerelektrodentreiberstufen übertragbar. Erfindungsgemäss ist mindestens ein Regelsignal und / oder ein Ansteuersignal mittels elektromagnetischer Strahlung übertragbar und der mindestens eine zugehörige erste oder zweite Übertragungsweg leitungslos. Durch die leitungslose Übertragung des mindestens einen Regelsignals und / oder des mindestens einen Ansteuersignals weist das Signalübertragungssystem eine verbesserte Zuverlässigkeit auf und wird zudem mechanisch stabil und gegen Staub unempfindlich. Bei der Herstellung einer leistungselektronischen Vorrichtung, welche einen Regler, mindestens einen ersten Übertragungsweg, mindestens einen Modulator, mindestens einen zweiten Übertragungsweg und mindestens einen Leistungshalbleiterschalter mit je einer-Ansteuerelektrodentreiberstufe umfasst, entfallen zudem die Kosten für die Verlegung der Lichtwellenleiter und / oder Kabel für den mindestens einen ersten und / oder zweiten Übertragungsweg, welcher leitungslos ist.

Falls mindestens ein Regelsignal mittels elektromagnetischer Strahlung übertragbar ist und der zugehörige mindestens eine erste Übertragungsweg leitungslos ist, besteht das zu übertragende mindestens eine Regelsignal aus einer kleinen Datenmenge, so dass keine hohe Übertragungsrate notwendig ist. Die Signalübertragung mittels elektromagnetischer Strahlung ist vorteilhaft, weil Daten zuverlässig übertragbar sind.

Falls mindestens ein Ansteuersignal mittels elektromagnetischer Strahlung übertragbar ist und der zugehörige mindestens eine zweite Übertragungsweg leitungslos ist, ist die Signalübertragung mittels elektromagnetischer Strahlung vorteilhaft, weil grosse Datenmengen zuverlässig übertragbar sind.

In einer anderen Ausführung der Erfindung ist mindestens ein Leistungshalbleiterschalter mit je einem Überwachungssensor zur Messung jeweils eines Zustandswerts verbunden. Mindestens ein dritter Übertragungsweg zum Übertragen von je einem Rückmeldesignal von mindestens einem der mindestens einen Überwachungssensoren führt zu mindestens einem Modulator oder dem Regler. Mindestens ein Rückmeldesignal ist mittels elektromagnetischer Strahlung übertragbar und der zugehörige mindestens eine dritte Übertragungsweg ist leitungslos. Vorteil dieser Ausführung ist, dass keine Verkabelung zwischen dem mindestens einen Überwachungssensor und dem mindestens einem Modulator oder dem Regler notwendig ist.

Eines der obengenannten Signalübertragungssysteme lässt sich vorteilhaft in einem Umrichter einsetzen, weil ein Umrichter mehrere Leistungshalbleiterschalter umfasst und diese mit dem erfindungsgemässen Signalübertragungssystem zuverlässig schaltbar sind und somit eine hohe Verfügbarkeit aufweisen. Solche erfindungsgemässen Umrichter sind zudem mechanisch stabil und weitestgehend unempfindlich gegen Verschmutzung.

Diese und weitere Aufgaben, Vorteile und Merkmale der vorliegenden Erfindung werden aus der nachfolgenden detaillierten Beschreibung von bevorzugten Ausführungsbeispielen der Erfindung in Verbindung mit den Zeichnungen offensichtlich.

### Kurze Beschreibung der Zeichnungen

Es zeigen:
- FIG 1: ein herkömmliches Signalübertragungssystem mit Sternstruktur;
- FIG 2: ein erfindungsgemässes Signalübertragungssystem mit einem leitungslosen ersten Übertragungsweg zwischen einem Regler und einem Modulator;
- FIG 3: ein erfindungsgemässes Signalübertragungssystem mit n leitungslosen ersten Übertragungswegen zwischen dem Regler und n Modulatoren;
- FIG 4: ein erfindungsgemässes Signalübertragungssystem mit n leitungslosen zweiten Übertragungswegen zwischen dem Modulator und n Ansteuerelektrodentreiberstufen;
- FIG 5: ein erfindungsgemässes Signalübertragungssystem mit n leitungslosen zweiten Übertragungswegen zwischen dem Modulator und n Ansteuerelektrodentreiberstufen, wobei ein moduliertes Ansteuersignalpaket von einem Sender aus übertragbar ist; und
- FIG 6: ein erfindungsgemässes Signalübertragungssystem mit n leitungslosen dritten Übertragungswegen zwischen n Überwachungssensoren und dem Regler.

Die in den Zeichnungen verwendeten Bezugszeichen sind in der Bezugszeichenliste zusammengefasst aufgelistet. Grundsätzlich sind in den Zeichnungen gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

In den folgenden Ausführungen ist unter einem Lichtwellenleiter zu verstehen, dass dieser einen Leiter zum Übertragen von Signalen sowie einen Lichtwellensender zum Senden von Signalen und einen Lichtwellenempfänger zum Empfangen von Signalen umfasst.

In FIG 2 ist eine erste Ausführungsform des erfindungsgemässen Gegenstands gezeigt. Zwischen einem Regler 11 und einem Modulator M₁ ist ein erster Übertragungsweg 3 angeordnet. Der Regler 11 ist mit einem Sender 5 zum Senden von elektromagnetischer Strahlung und der Modulator M₁ mit einem Empfänger 6 zum Empfangen von elektromagnetischer Strahlung verbunden. Der erste Übertragungsweg 3 ist leitungslos. Dies ist in FIG 2 durch eine gestrichelte Linie zwischen dem Regler 11 und dem Modulator M₁ dargestellt. Eine leistungselektronische Schaltung 2 umfasst mindestens eine Ansteuerelektrodentreiberstufe G₁, G₂, ..., Gₙ und mindestens einen Leistungshalbleiterschalter S₁, S₂, ..., Sₙ. Von dem Modulator M₁ gehen auf jeweils einem zweiten Übertragungsweg 4 Lichtwellenleiter wie Glasfaserkabel oder Fiberoptik-Kabel aus Kunststoff zu jeder der Ansteuerelektrodentreiberstufen G₁, G₂, ..., Gₙ. Jede der Ansteuerelektrodentreiberstufen G₁, G₂, ..., Gₙ ist mit jeweils einem Leistungshalbleiterschalter S₁, S₂, ..., Sₙ verbunden.

In FIG 2 wird ein Referenzwert 7 zum Regler 11 gesendet. Aus dem Referenzwert 7 wird in dem Regler 11 ein Regelsignal ermittelt. Von dem Sender 5 aus wird über den ersten Übertragungsweg 3 das Regelsignal mittels elektromagnetischer Strahlung an den Empfänger 6 gesendet. In dem Modulator M₁ wird aus dem Regelsignal ermittelt, wann die einzelnen Schalter S₁, S₂, ..., Sₙ geschaltet werden sollen. Von dem Modulator M₁ wird über jeweils einen zweiten Übertragungsweg 4 je ein Ansteuersignal an je eine Ansteuerelektrodentreiberstufe G₁, G₂, ..., Gₙ übertragen mit dem Befehl, den mit jeder Ansteuerelektrodentreiberstufe G₁, G₂, ..., Gₙ verbundenen Schalter S₁, S₂, ..., Sₙ einzuschalten oder auszuschalten. Die Ansteuerelektrodentreiberstufen G₁, G₂, ..., Gₙ lösen dann das Umschalten in den zugehörigen Schaltern S₁, S₂, ..., Sₙ aus.

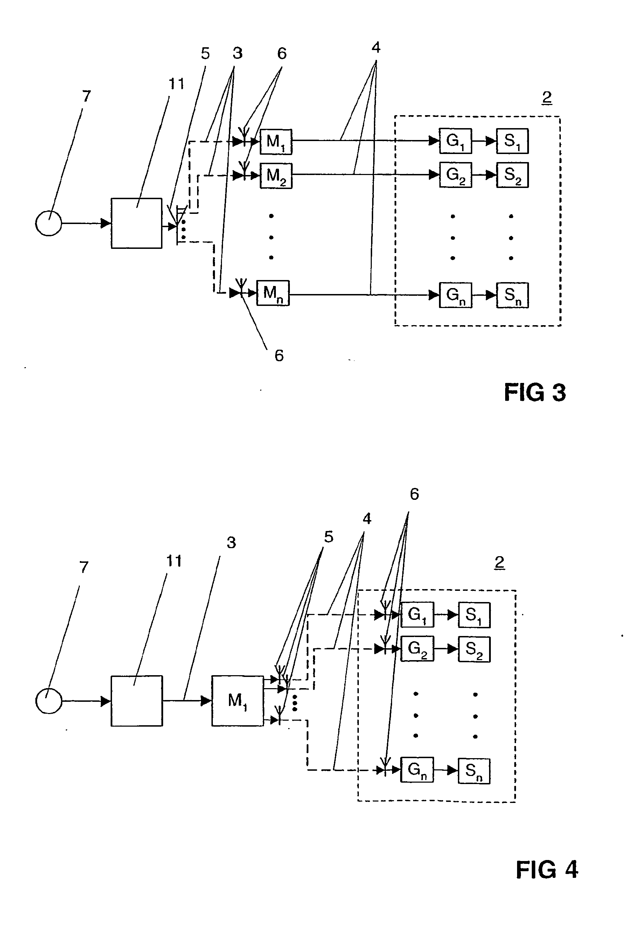

In einer in FIG 3 dargestellten Variante sind mehrere erste Übertragungswege 3 zwischen dem Regler 11 und mehreren Modulatoren M₁, M₂, ..., Mₙ ausgebildet. Der Regler 11 ist mit einem Sender 5 verbunden. Der mindestens eine Modulator M₁, M₂, ..., Mₙ ist mit je einem Empfänger 6 verbunden. Jeweils ein zweiter Übertragungsweg 4 führt von den Modulatoren M₁, M₂, ..., Mₙ zu je einer Ansteuerelektrodentreiberstufe G₁, G₂, ..., Gₙ. Jede der Ansteuerelektrodentreiberstufen G₁, G₂, ..., Gₙ ist mit jeweils einem Leistungshalbleiterschalter S₁, S₂, ..., Sₙ verbunden.

In FIG 3 wird ein Referenzwert 7 zum Regler 11 gesendet. Aus dem Referenzwert 7 wird in dem Regler 11 ein Regelsignal ermittelt. Von dem Regler 11 aus wird über die mehreren ersten Übertragungswege 3 das Regelsignal an die mehreren Modulatoren M₁, M₂, ..., Mₙ mittels elektromagnetischer Strahlung gesendet. Jeder Modulator M₁, M₂, ..., Mₙ ermittelt für einen zugehörigen Schalter S₁, S₂, ..., Sₙ, wann dieser Schalter S₁, S₂, ..., Sₙ geschaltet werden soll und sendet über je einen zweiten Übertragungsweg 4 je ein Ansteuersignal an die zugehörige Ansteuerelektrodentreiberstufe G₁, G₂, ..., Gₙ. Die Ansteuerelektrodentreiberstufen G₁, G₂, ..., Gₙ lösen dann das Umschalten in den zugehörigen Schaltern S₁, S₂, ..., Sₙ aus.

Die in den FIG 2 und FIG 3 dargestellten Ausführungsformen lassen sich vorteilhaft in einem Signalübertragungssystem einsetzen, in dem eine Ansteuereinrichtung 1 einen Regler 11 umfasst und die leistungselektronische Schaltung 2 den mindestens einen Modulator M₁, M₂, ..., Mₙ und die mindestens eine Ansteuerelektrodentreiberstufe G₁, G₂, ..., Gₙ mit dem jeweils zugehörigen Schalter S₁, S₂, ..., Sₙ umfasst. In einer solchen Anordnung ist der mindestens eine leitungslose erste Übertragungsweg 3 zwischen dem Regler 11 in der Ansteuereinrichtung 1 und dem mindestens einen Modulator M₁, M₂, ..., Mₙ in der leistungselektronischen Schaltung 2 angeordnet. Dadurch sind keine Lichtwellenleiter zwischen der Ansteuereinrichtung 1 und der leistungselektronischen Schaltung 2 oder zumindest dem Teil der leistungselektronischen Schaltung 2, bei welchem der mindestens eine erste Übertragungsweg 3 zu dem mindestens einen Modulator M₁, M₂, ..., Mₙ leistungslos ist, erforderlich und das Signalübertragungssystem weist eine verbesserte Zuverlässigkeit auf und wird zudem mechanisch stabil sowie gegen Verschmutzung robust.

In FIG 4 ist eine weitere Ausführungsform des erfindungsgemässen Gegenstands gezeigt. Zwischen einem Regler 11 und einem Modulator M₁ ist ein erster Übertragungsweg 3 ausgebildet. Auf dem ersten Übertragungsweg 3 sind der Regler 11 mit dem Modulator M₁ über ein Kabel verbunden. Eine leistungselektronische Schaltung 2 umfasst mindestens eine Ansteuerelektrodentreiberstufe G₁, G₂, ..., Gₙ und mindestens einen Leistungshalbleiterschalter S₁, S₂, ..., Sₙ. Je ein zweiter Übertragungsweg 4 führt von dem Modulator M₁ zu der mindestens einen Ansteuerelektrodentreiberstufe G₁, G₂, ..., Gₙ. Der Modulator M₁ ist mit mindestens einem Sender 5 und die mindestens eine Ansteuerelektrodentreiberstufe G₁, G₂, ..., Gₙ mit jeweils einem Empfänger 6 verbunden. Mindestens ein zweiter Übertragungsweg 4 ist leitungslos. Dies ist in FIG 4 durch gestrichelte Linien zwischen dem Modulator M₁ und jeder der Ansteuerelektrodentreiberstufen G₁, G₂, ..., Gₙ dargestellt. Jede der Ansteuerelektrodentreiberstufen G₁, G₂, ..., Gₙ ist mit je einem Leistungshalbleiterschalter S₁, S₂, ..., Sₙ verbunden.

In FIG 4 wird ein Referenzwert 7 zum Regler 11 gesendet. Aus dem Referenzwert 7 wird in dem Regler 11 ein Regelsignal ermittelt. Vom Regler 11 aus wird über den ersten Übertragungsweg 3 ein Regelsignal an den Modulator M₁ gesendet, in welchem aus dem Regelsignal der Tastgrad für jeden einzelnen Schalter ermittelt wird. Von dem Sender 5 aus wird über je einen zweiten Übertragungsweg 4 je ein Ansteuersignal mittels elektromagnetischer Strahlung an je eine Ansteuerelektrodentreiberstufe G₁, G₂, ..., Gₙ übertragen mit dem Befehl, den zugehörigen Schalter S₁, S₂, ..., Sₙ einzuschalten oder auszuschalten.

In einer Variante der in FIG 4 gezeigten Ausführung wird als Ansteuersignal nur der Tastgrad jeden einzelnen Schalters S₁, S₂, ..., Sₙ an die mindestens eine Ansteuerelektrodentreiberstufe G₁, G₂, ..., Gₙ gesendet. Jede Ansteuerelektrodentreiberstufe G₁, G₂, ..., Gₙ ist mit einer Logik verbunden, in der aus dem Tastgrad ermittelt wird, zu welchem Zeitpunkt der zugehörige Schalter S₁, S₂, ..., Sₙ geschaltet werden soll.

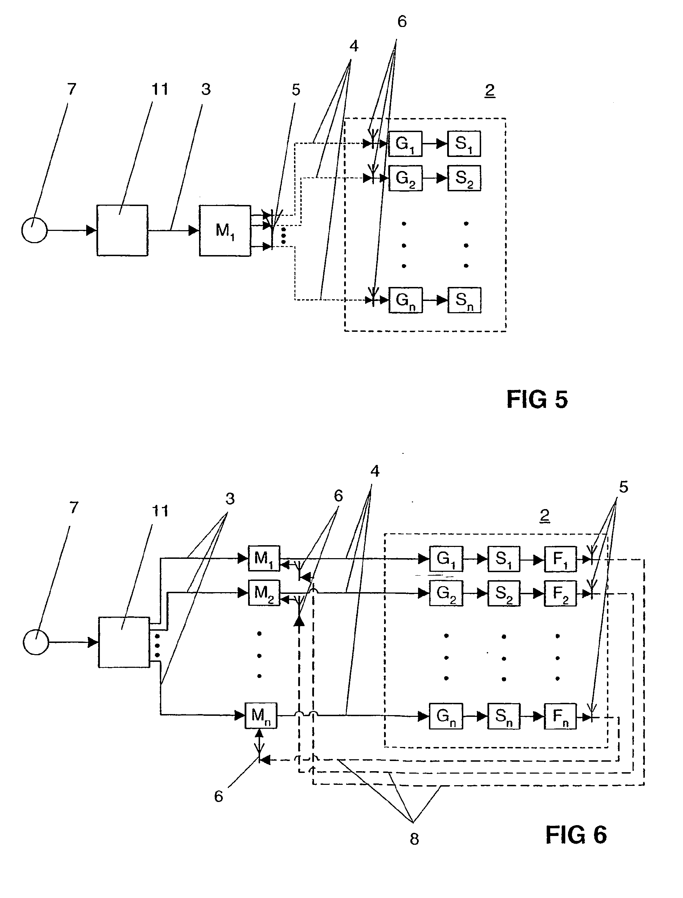

In FIG 5 ist eine weitere Ausführungsform des erfindungsgemässen Gegenstands gezeigt. Zwischen einem Regler 11 und einem Modulator M₁ ist ein erster Übertragungsweg 3 ausgebildet. Auf dem ersten Übertragungsweg 3 sind der Regler 11 mit dem Modulator M₁ über ein Kabel verbunden. Eine leistungselektronische Schaltung 2 umfasst mindestens eine Ansteuerelektrodentreiberstufe G₁, G₂, ..., Gₙ und mindestens einen Leistungshalbleiterschalter S₁, S₂, ..., Sₙ. Je ein zweiter Übertragungsweg 4 führt von dem Modulator M₁ zu der mindestens einen Ansteuerelektrodentreiberstufe G₁, G₂, ..., Gₙ. Der Modulator M₁ ist mit einem Sender 5 und die mindestens eine Ansteuerelektrodentreiberstufe G₁, G₂,...,Gₙ mit jeweils einem Empfänger 6 verbunden. Mindestens ein zweiter Übertragungsweg 4 ist leitungslos. Dies ist in FIG 5 durch gestrichelte Linien zwischen dem Modulator M₁ und jeder der Ansteuerelektrodentreiberstufen G₁, G₂, ..., Gₙ dargestellt. Jede der Ansteuerelektrodentreiberstufen G₁, G₂, ..., Gₙ ist mit je einem Leistungshalbleiterschalter S₁, S₂, ..., Sₙ verbunden.

In FIG 5 wird ein Referenzwert 7 zum Regler 11 gesendet. Aus dem Referenzwert 7 wird in dem Regler 11 ein Regelsignal ermittelt. Vom Regler 11 aus wird über den ersten Übertragungsweg 3 ein Regelsignal an den Modulator M₁ gesendet, in welchem aus dem Regelsignal der Tastgrad für jeden einzelnen Schalter ermittelt wird. In dem Modulator M₁ werden mindestens zwei der Ansteuersignale mittels eines gängigen Modulationsverfahrens moduliert und in ein moduliertes Ansteuersignalpaket verpackt. Von dem Sender 5 aus wird das modulierte Ansteuersignalpaket mittels elektromagnetischer Strahlung an die zugehörigen Ansteuerelektrodentreiberstufen G₁, G₂, ..., Gₙ über je einen zweiten Übertragungsweg 4 übertragen mit dem Befehl, die zugehörigen Schalter S₁, S₂, ..., Sₙ einzuschalten oder auszuschalten. In den zugehörigen Ansteuerelektrodentreiberstufen G₁, G₂, ..., Gₙ wird das modulierte Ansteuersignalpaket demoduliert und die entsprechenden Ansteuersignale den Ansteuerelektrodentreiberstufen G₁, G₂, ..., Gₙ zugeordnet. Die Ansteuerelektrodentreiberstufen G₁, G₂, ..., Gₙ lösen dann das Umschalten in den zugehörigen Schaltern S₁, S₂, ..., Sₙ aus.

In einer Variante der in FIG 5 gezeigten Ausführung werden in dem Modulator M₁ mindestens zwei der Tastgrade jeden einzelnen Schalters S₁, S₂, ..., Sₙ mittels eines gängigen Modulationsverfahrens moduliert und in ein moduliertes Ansteuersignalpaket verpackt und an die mindestens eine Ansteuerelektrodentreiberstufe G₁, G₂, ..., Gₙ gesendet. In den zugehörigen Ansteuerelektrodentreiberstufen G₁, G₂, ..., Gₙ wird das modulierte Ansteuersignalpaket demoduliert und die entsprechenden Tastgrade den Ansteuerelektrodentreiberstufen G₁, G₂, ..., Gₙ zugeordnet. Die zugehörigen Ansteuerelektrodentreiberstufen G₁, G₂, ..., Gₙ sind mit je einer Logik verbunden, in der aus dem Tastgrad ermittelt wird, zu welchem Zeitpunkt der zugehörige Schalter S₁, S₂, ..., Sₙ geschaltet werden soll. Die Ansteuerelektrodentreiberstufen G₁, G₂, ..., Gₙ lösen dann das Umschalten in den zugehörigen Schaltern S₁, S₂, ..., Sₙ aus.

In einer weiteren, der Übersichtlichkeit wegen nicht dargestellten Ausführungsform ist mindestens ein Regelsignal mittels elektromagnetischer Strahlung übertragbar ist und der mindestens eine zugehörige erste Übertragungsweg 3 ist leitungslos sowie mindestens ein Ansteuersignal mittels elektromagnetischer Strahlung übertragbar ist und der mindestens eine zugehörige zweite Übertragungsweg 4 ist leitungslos.

In FIG 6 ist eine weitere Ausführungsform des erfindungsgemässen Gegenstands gezeigt. Zwischen einem Regler 11 und mindestens einem Modulator M₁, M₂, ..., Mₙ ist mindestens ein zugehöriger erster Übertragungsweg 3 ausgebildet. Auf dem mindestens einen ersten Übertragungsweg 3 ist der Regler 11 mit dem mindestens einen Modulator M₁, M₂, ..., Mₙ über Lichtwellenleiter verbunden. Eine leistungselektronische Schaltung 2 umfasst mindestens eine Ansteuerelektrodentreiberstufe G₁, G₂, ..., Gₙ, mindestens einen Leistungshalbleiterschalter S₁, S₂, ..., Sₙ und mindestens einen Überwachungssensor F₁, F₂, ..., Fₙ. Von dem mindestens einen Modulator M₁, M₂, ..., Mₙ gehen auf jeweils einem zweiten Übertragungsweg 4 Lichtwellenleiter wie Glasfaserkabel oder Fiberoptik-Kabel aus Kunststoff zu jeder der Ansteuerelektrodentreiberstufen G₁, G₂, ..., Gₙ. Jede der Ansteuerelektrodentreiberstufen G₁, G₂, ..., Gₙ ist mit jeweils einem Leistungshalbleiterschalter S₁, S₂, ..., Sₙ verbunden. Mindestens ein Leistungshalbleiterschalter S₁, S₂, ..., Sₙ ist mit je einem Überwachungssensor F₁, F₂, ..., Fₙ verbunden. Zwischen mindestens einem Überwachungssensor F₁, F₂, ..., Fₙ und dem mindestens einen Modulator M₁, M₂, ..., Mₙ ist jeweils ein dritter Übertragungsweg 8 ausgebildet. Mindestens ein Überwachungssensor F₁, F₂, ..., Fₙ ist mit einem Sender 5 zum Senden von elektromagnetischer Strahlung und der mindestens eine Modulator M₁, M₂, ..., Mₙ mit einem Empfänger 6 zum Empfangen von elektromagnetischer Strahlung verbunden. Der mindestens eine zugehörige dritte Übertragungsweg 8 ist leitungslos. Dies ist in FIG 6 durch eine gestrichelte Linie zwischen den Überwachungssensoren F₁, F₂, ..., Fₙ und dem mindestens einen Modulator M₁, M₂, ..., Mₙ dargestellt.

In FIG 6 wird ein Referenzwert 7 zum Regler 11 gesendet. Aus dem Referenzwert 7 wird in dem Regler 11 ein Regelsignal ermittelt. Von dem Regler 11 aus wird über den mindestens einen ersten Übertragungsweg 3 das mindestens eine Regelsignal an den mindestens einen Modulator M₁, M₂, ..., Mₙ gesendet. In dem mindestens einen Modulator M₁, M₂, ..., Mₙ wird aus dem Regelsignal ermittelt, wann der mindestens eine Schalter S₁, S₂, ..., Sₙ geschaltet werden soll. Von dem mindestens einen Modulator M₁, M₂, ..., Mₙ wird über jeweils einen zweiten Übertragungsweg 4 je ein Ansteuersignal an je eine Ansteuerelektrodentreiberstufe G₁, G₂, ..., Gₙ übertragen mit dem Befehl, den mit jeder Ansteuerelektrodentreiberstufe G₁, G₂, ..., Gₙ verbundenen Schalter S₁, S₂, ..., Sₙ einzuschalten oder auszuschalten. Die Ansteuerelektrodentreiberstufen G₁, G₂, ..., Gₙ lösen dann das Umschalten in den zugehörigen Schaltern S₁, S₂, ..., Sₙ aus. Mit dem mindestens einen Überwachungssensor F₁, F₂, ..., Fₙ wird ein Zustand einer einzelnen Komponente der leistungselektronischen Schaltung 2 oder der gesamten leistungselektronischen Schaltung 2 wie eine Spannung oder ein Strom gemessen. Der Zustandswert wird als Rückmeldesignal leitungslos von dem Sender 5 an den Empfänger 6 übermittelt und in der Ermittlung des Tastgrades der Schalter S₁, S₂, ..., Sₙ berücksichtigt.

Es ist auch möglich, dass es sich bei dem Zustandswert um eine Information wie einen Fehler, beispielsweise einen Ausfall eines Schalters S₁, S₂, ..., Sₙ oder einen Fehler in einem der übertragenen Signale handelt.

In einer Variante zu der in FIG 6 gezeigten Ausführungsform der Erfindung geht der mindestens eine dritte Übertragungsweg 8 von dem mindestens einen Überwachungssensor F₁, F₂, ..., Fₙ zu dem Regler 11.

In einer anderen Variante zu der in FIG 6 gezeigten Ausführungsform kann der mindestens eine Überwachungssensor F₁, F₂, ..., Fₙ statt mit mindestens einem Leistungshalbleiterschalter S₁, S₂, ..., Sₙ auch mit anderen Komponenten in der leistungselektronischen Schaltung 2 vebunden sein.

Als weitere Variante zu der in FIG 6 gezeigten Ausführungsform ist es auch denkbar, dass mindestens eine Ansteuerelektrodentreiberstufe G₁, G₂, ..., Gₙ eine Logik umfasst, mittels derer die entsprechende Ansteuerelektrodentreiberstufe auf Fehler reagieren kann. Das mindestens eine Rückmeldesignal kann mittels elektromagnetischer Strahlung und leitungslos direkt an mindestens eine Ansteuerelektrodentreiberstufe G₁, G₂, ..., Gₙ übertragen werden und dort in der Schaltung der zugehörigen Schalter S₁, S₂, ..., Sₙ berücksichtigt werden.

In einer weiteren, der Übersichtlichkeit nicht dargestellten Ausführungsform ist mindestens ein Rückmeldesignal mittels elektromagnetischer Strahlung übertragbar ist und der mindestens eine zugehörige dritte Übertragungsweg 8 ist leitungslos. Zudem ist mindestens ein Regelsignal mittels elektromagnetischer Strahlung übertragbar ist und der mindestens eine zugehörige erste Übertragungsweg 8 leitungslos und / oder mindestens ein Ansteuersignal mittels elektromagnetischer Strahlung übertragbar ist und der mindestens eine zugehörige zweite Übertragungsweg 4 leitungslos.

Das mindestens eine Regelsignal und / oder das mindestens eine Ansteuersignal und / oder das mindestens eine Rückmeldesignal können für die Übertragung mittels elektromagnetischer Strahlung mit einem Modulationsverfahrens moduliert werden. Als Modulationsverfahren sind gängige Modulationsverfahren wie beispielsweise Frequenzmodulation, Zeitmodulation oder Phasenmodulation geeignet. Als mindestens eine Trägerfrequenz für eine solche Modulation eignet sich elektromagnetische Strahlung im Bereich von 0.4 GHz bis 400 GHz (Gigahertz) besonders. In Umrichtern tritt Rauschen bei Frequenzen bis zu einigen Hundert Hertz auf, so dass bei Übertragung von Signalen im Gigahertzbereich diese nicht beeinträchtigt werden durch das Rauschen im Umrichter. Zudem ist die Übertragungsrate in diesem Frequenzbereich hoch und die Signalübertragung ist kostengünstig.

Es können Antennen als der mindestens eine Sender 5 und der mindestens eine Empfänger 6 eingesetzt werden, deren Sendebereich und / oder Empfangsbereich für den Frequenzbereich, in dem das oder die entsprechenden Signale übertragen werden, ausgelegt sind.

Die vorgängig beschriebenen Ausführungen des erfindungsgemässen Gegenstands umfassen nur einen Regler 11. Es ist aber auch denkbar, dass das Signalübertragungssystem mehrere Regler 11 umfasst und von jedem der Regler mindestens ein Regelsignal an je mindestens einen Modulator M₁, M₂, ..., Mₙ übertragen wird.

Jeder der mindestens einen ersten und / oder zweiten Übertragungswege 3, 4, kann auch dazu verwendet werden, um Rückmeldesignale auf dem entsprechenden Übertragungsweg 3, 4 zurückzusenden und dadurch eine schnelle Zustandsrückmeldung der einzelnen Komponenten zu ermöglichen. In diesem Fall ist beispielsweise der Regler 11 mit einem Sender 5 zum Senden des mindestens einen Regelsignals und einem Empfänger 6 zum Empfangen von mindestens einem Rückmeldesignal von mindestens einem Modulator M₁, M₂, ..., Mₙ aus verbunden. Mindestens ein Modulator M₁, M₂, ..., Mₙ ist mit einem Empfänger 6 zum Empfangen von mindestens einem Regelsignal und mindestens einem Sender 5 zum Senden von mindestens einem Rückmeldesignal verbunden. Es kann sich auch um Sende-/Empfangseinheiten handeln, welche je einen Sender 5 und einen Empfänger 6 umfassen und mit denen sowohl elektromagnetische Strahlung gesendet wie auch empfangen werden kann.

Eines der obengenannten Signalübertragungssysteme lässt sich vorteilhaft in einem Umrichter einsetzen, weil ein Umrichter mehrere Leistungshalbleiterschalter S₁, S₂, ..., Sₙ umfasst und diese mit dem erfindungsgemässen Signalübertragungssystem zuverlässig schaltbar sind und somit eine hohe Verfügbarkeit aufweisen. Die erfindungsgemässen Umrichter sind zudem mechanisch stabil und weitestgehend unempfindlich gegen Verschmutzung.

### Bezugszeichenliste

- 1: Ansteuereinrichtung
- 11: Regler
- 2: leistungselektronische Schaltung
- 3: Erster Übertragungsweg
- 4: Zweiter Übertragungsweg
- 5: Sender
- 6: Empfänger
- 7: Referenzwert
- 8: Dritter Übertragungsweg
- M₁, M₂, ..., Mₙ: Modulator
- G₁, G₂, ..., Gₙ: Ansteuerelektrodentreiberstufe
- S₁, S₂, ..., Sₙ: Leistungshalbleiterschalter
- F₁, F₂, ..., Fₙ: Überwachungssensor

## Patentansprüche

1. Signalübertragungssystem zur Ansteuerung mindestens eines Leistungshalbleiterschalters (S₁, S₂, ..., Sₙ) einer leistungselektronischen Schaltung (2) von einem Regler (11) aus, wobei jeder Leistungshalbleiterschalter (S₁, S₂, ..., Sₙ) mit je einer Ansteuerelektrodentreiberstufe (G₁, G₂, ..., Gₙ) verbunden ist,
von dem Regler (11) mindestens ein Regelsignal an mindestens einen Modulator (M₁, M₂, ..., Mₙ) über mindestens einen ersten Übertragungsweg (3) übertragbar ist und
von dem mindestens einen Modulator (M₁, M₂, ..., Mₙ) mindestens ein Ansteuersignal an jede der Ansteuerelektrodentreiberstufen (G₁, G₂,..., Gₙ) über je einen zweiten Übertragungsweg (4) übertragbar ist, **dadurch gekennzeichnet, dass**
mindestens ein Regelsignal und / oder mindestens ein Ansteuersignal mittels elektromagnetischer Strahlung von einem Sender (5), welcher eine Antenne zum Senden von elektromagnetischer Strahlung aufweist, an einen Empfänger (6), welcher eine Antenne zum Empfangen von elektromagnetischer Strahlung aufweist, übertragbar ist, und dessen mindestens einer zugehöriger Übertragungsweg (3, 4) leitungslos ist, dass das mindestens eine Regelsignal und / oder mindestens eine Ansteuersignal mit einem Modulationsverfahren moduliert ist und mindestens eine Trägerfrequenz im Bereich von 0.4 GHz bis 400 GHz aufweist,
wobei der mindestens eine zugehörige Übertragungsweg (3, 4) leitungslos ist.

2. Signalübertragungssystem nach Anspruch 1, **dadurch gekennzeichnet, dass**
das mindestens eine Regelsignal mittels elektromagnetischer Strahlung übertragbar ist und der mindestens eine zugehörige erste Übertragungsweg (3) leitungslos ist, dass
der Regler (11) einen Sender (5), welcher eine Antenne zum Senden von elektromagnetischer Strahlung aufweist, umfasst, dass mindestens ein Modulator (M₁, M₂, ..., Mₙ) einen Empfänger (6), welcher eine Antenne zum Empfangen von elektromagnetischer Strahlung aufweist, umfasst und der Regler (11) mit dem Sender (5) verbunden ist und dass
der mindestens eine Modulator (M₁, M₂, ..., Mₙ) mit je einem Empfänger (6) verbunden ist.

3. Signalübertragungssystem nach Anspruch 1, **dadurch gekennzeichnet, dass**
das mindestens eine Ansteuersignal mittels elektromagnetischer Strahlung übertragbar ist, dass
der mindestens eine zugehörige zweite Übertragungsweg (4) leitungslos ist, dass
mindestens ein Modulator (M₁, M₂, ..., Mₙ) mit je einem Sender (5), welcher eine Antenne zum Senden von elektromagnetischer Strahlung aufweist, verbunden ist, dass
mindestens eine Ansteuerelektrodentreiberstufe (G₁, G₂, ..., Gₙ) mit je einem Empfänger (6), welcher eine Antenne zum Empfangen von elektromagnetischer Strahlung aufweist, verbunden ist und
je ein zweiter Übertragungsweg (4) von jedem Sender (5) zu je einem Empfänger (6) führt.

4. Signalübertragungssystem nach Anspruch 1, **dadurch gekennzeichnet, dass**
mindestens einer der Leistungshalbleiterschalter (S₁, S₂, ..., Sₙ) mit jeweils einem Überwachungssensor (F₁, F₂, ..., Fₙ) zur Messung jeweils eines Zustandswerts verbunden ist, dass
der mindestens eine Zustandswert in jeweils ein Rückmeldesignal umwandelbar ist, dass
mindestens ein dritter Übertragungsweg (8) zum Übertragen von jeweils einem Rückmeldesignal von mindestens einem der
Überwachungssensoren (F₁, F₂, ..., Fₙ) zu mindestens einem Modulator (M₁, M₂, ..., Mₙ) oder dem Regler (11) führt, dass das mindestens eine Rückmeldesignal mittels elektromagnetischer Strahlung übertragbar ist und
der mindestens eine zugehörige dritte Übertragungsweg (8) leitungslos ist.

5. Signalübertragungssystem nach Anspruch 4, **dadurch gekennzeichnet, dass**
der mindestens eine Überwachungssensor (F₁, F₂...., Fₙ) je einen Sender (5), welcher eine Antenne zum Senden von elektromagnetischer Strahlung aufweist, umfasst, dass
der mindestens eine Modulator (M₁, M₂, ..., Mₙ) oder der Regler (11) je einen Empfänger (6), welcher eine Antenne zum Empfangen von elektromagnetischer Strahlung aufweist, umfasst, dass mindestens ein Überwachungssensor (F_{1,} F₂, .... Fₙ) mit jeweils einem Sender (5) verbunden ist und
der mindestens eine Modulator (M₁, M₂, ..., Mₙ) oder der Regler (11) mit dem mindestens einen Empfänger (6) verbunden ist.

6. Signalübertragungssystem zur Ansteuerung mindestens eines Leistungshalbleiterschalters (S₁, S₂, ..., Sₙ) einer leistungselektronischen Schaltung (2) von einem Regler (11) aus, wobei jeder Leistungshalbleiterschalter (S₁, S₂, ..., Sₙ) mit je einer Ansteuerelektrodentreiberstufe (G₁, G₂, ..., Gₙ) verbunden ist,
von dem Regler (11) mindestens ein Regelsignal an mindestens einen Modulator (M₁, M₂, ..., Mₙ) über mindestens einen ersten Übertragungsweg (3) übertragbar ist,
von dem mindestens einen Modulator (M₁, M₂, ..., Mₙ) mindestens ein Ansteuersignal an jede der Ansteuerelektrodentreiberstufen (G₁, G₂, ..., Gₙ) über je einen zweiten Übertragungsweg (4) übertragbar ist, mindestens einer der Leistungshalbleiterschalter (S₁, S₂, ..., Sₙ) mit je
einem Überwachungssensor (F₁, F₂, ..., Fₙ) zur Messung jeweils eines Zustandswerts verbunden ist,
der mindestens eine Zustandswert in jeweils ein Rückmeldesignal umwandelbar ist,
mindestens ein dritter Übertragungsweg (8) zum Übertragen von jeweils einem Rückmeldesignal von mindestens einem der Überwachungssensoren (F₁, F₂, ..., Fₙ) zu mindestens einem Modulator (M₁, M₂, ..., Mₙ) oder dem Regler (11) führt, und
mindestens ein Rückmeldesignal mittels elektromagnetischer Strahlung übertragbar ist,
**dadurch gekennzeichnet, dass**
der mindestens eine Überwachungssensor (F₁. F₂, ..., Fₙ) jeweils einen Sender (5), welcher eine Antenne zum Senden von elektromagnetischer Strahlung aufweist, umfasst, dass
mindestens ein Modulator (M₁, M₂, ..., Mₙ) oder der Regler (11) je einen Empfänger (6), welcher eine Antenne zum Empfangen von elektromagnetischer Strahlung aufweist, umfasst, dass mindestens ein Überwachungssensor (F₁, F₂, ..., Fₙ) mit jeweils einem Sender (5) verbunden ist, dass
mindestens ein Modulator (M₁, M₂, ..., Mₙ) oder der Regler (11) mit dem mindestens einen Empfänger (6) verbunden ist, dass das mindestens eine Rückmeldesignal mit einem Modulationsverfahren moduliert ist und mindestens eine Trägerfrequenz im Bereich von 0.4 GHz bis 400 GHz aufweist, und dass
der zugehörige, mindestens eine dritte Übertragungsweg (8) leitungslos ist.

7. Umrichter, mehrere Leistungshalbleiterschalter S₁, S₂, ..., Sₙ umfassend, mit einem Signalübertragungssystem nach einem der Ansprüche 1 bis 6.

## Claims

1. Signal transmission system for driving at least one power semiconductor switch (S₁, S₂, ..., Sₙ) of a power-electronics circuit (2) from a controller (11), each power semiconductor switch (S₁, S₂, ..., Sₙ) being connected to a respective drive electrode driver stage (G₁, G₂, ... , Gₙ),
the controller (11) being able to transmit at least one control signal to at least one modulator (M₁, M₂, ..., Mₙ) using at least one first transmission path (3), and
the at least one modulator (M₁, M₂, ... , Mₙ) being able to transmit at least one drive signal to each of the drive electrode driver stages (G₁, G₂, ..., Gₙ) using a respective second transmission path (4), **characterized in that**
at least one control signal and/or at least one drive signal can be transmitted from a transmitter (5), which has an antenna for transmitting electromagnetic radiation, to a receiver (6), which has an antenna for receiving electromagnetic radiation, using electromagnetic radiation, and the at least one associated transmission path (3, 4) of which is wireless, **in that** the at least one control signal and/or at least one drive signal is/are modulated using a modulation method and has/have at least one carrier frequency in the range from 0.4 GHz to 400 GHz,
the at least one associated transmission path (3, 4) being wireless.

2. Signal transmission system according to Claim 1, **characterized in that**
the at least one control signal can be transmitted using electromagnetic radiation and the at least one associated first transmission path (3) is wireless, **in that**
the controller (11) comprises a transmitter (5) having an antenna for transmitting electromagnetic radiation, **in that**
at least one modulator (M₁, M₂, ..., Mₙ) comprises a receiver (6) having an antenna for receiving electromagnetic radiation and the controller (11) is connected to the transmitter (5), and **in that** the at least one modulator (M₁, M₂, ..., Mₙ) is connected to a respective receiver (6).

3. Signal transmission system according to Claim 1, **characterized in that**
the at least one drive signal can be transmitted using electromagnetic radiation, **in that** the at least one associated second transmission path (4) is wireless, **in that**
at least one modulator (M₁, M₂, ..., Mₙ) is connected to a respective transmitter (5) having an antenna for transmitting electromagnetic radiation, **in that**
at least one drive electrode driver stage (G₁, G₂, ..., Gₙ) is connected to a respective receiver (6) having an antenna for receiving electromagnetic radiation, and
a respective second transmission path (4) leads from each transmitter (5) to a respective receiver (6).

4. Signal transmission system according to Claim 1, **characterized in that**
at least one of the power semiconductor switches (S₁, S₂, ..., Sn) is connected to a respective monitoring sensor (F₁, F₂, ..., Fₙ) for measuring a respective state value, **in that**
the at least one state value can be converted into a respective feedback signal, **in that** at least one third transmission path (8) leads from at least one of the monitoring sensors (F₁, F₂, ..., Fₙ) to at least one modulator (M₁, M₂, ..., Mₙ) or to the controller (11) for the purpose of transmitting a respective feedback signal, **in that** the at least one feedback signal can be transmitted using electromagnetic radiation, and the at least one associated third transmission path (8) is wireless.

5. Signal transmission system according to Claim 4, **characterized in that**
the at least one monitoring sensor (F₁, F₂, ..., Fₙ) comprises a respective transmitter (5) having an antenna for transmitting electromagnetic radiation, **in that**
the at least one modulator (M₁, M₂, ..., Mₙ) or the controller (11) comprises a respective receiver (6) having an antenna for receiving electromagnetic radiation, **in that**
at least one monitoring sensor (F₁, F₂, ... , Fₙ) is connected to a respective transmitter (5), and
the at least one modulator (M₁, M₂, ... , Mₙ) or the controller (11) is connected to the at least one receiver (6).

6. Signal transmission system for driving at least one power semiconductor switch (S₁, S₂, ..., Sₙ) of a power-electronics circuit (2) from a controller (11), each power semiconductor switch (S₁, S₂, ..., Sₙ) being connected to a respective drive electrode driver stage (G₁, G₂, ..., Gₙ),
the controller (11) being able to transmit at least one control signal to at least one modulator (M₁, M₂, ..., Mₙ) using at least one first transmission path (3),
the at least one modulator (M₁, M₂, ... , Mₙ) being able to transmit at least one drive signal to each of the drive electrode driver stages (G₁, G₂, ... , Gₙ) using a respective second transmission path (4),
at least one of the power semiconductor switches (S₁, S₂, ..., Sₙ) being connected to a respective monitoring sensor (F₁, F₂, ... , Fₙ) for measuring a respective state value,
the at least one state value being able to be converted into a respective feedback signal,
at least one third transmission path (8) leading from at least one of the monitoring sensors (F₁, F₂, ..., Fₙ) to at least one modulator (M₁, M₂, ..., Mₙ) or to the controller (11) for the purpose of transmitting a respective feedback signal, and
at least one feedback signal being able to be transmitted using electromagnetic radiation, **characterized in that**
the at least one monitoring sensor (F₁, F₂, ..., Fₙ) comprises a respective transmitter (5) having an antenna for transmitting electromagnetic radiation, **in that**
at least one modulator (M₁, M₂, ..., Mₙ) or the controller (11) comprises a respective receiver (6) having an antenna for receiving electromagnetic radiation, **in that**
at least one monitoring sensor (F₁, F₂, ... , Fₙ) is connected to a respective transmitter (5), **in that** at least one modulator (M₁, M₂, ..., Mₙ) or the controller (11) is connected to the at least one receiver (6), **in that**
the at least one feedback signal is modulated using a modulation method and has at least one carrier frequency in the range from 0.4 GHz to 400 GHz, and **in that**
the associated at least one third transmission path (8) is wireless.

7. Converter comprising a plurality of power semiconductor switches S₁, S₂, ... , Sₙ and having a signal transmission system according to one of Claims 1 to 6.

## Revendications

1. Système de transmission de signal pour commander au moins un commutateur semiconducteur de puissance (S₁, S₂, ..., Sₙ) d'un circuit électronique de puissance (2) depuis un régulateur (11), chaque commutateur semiconducteur de puissance (S₁, S₂, ..., Sₙ) étant à chaque fois relié avec un étage d'attaque d'électrode d'excitation (glu G₂, ..., Gₙ), au moins un signal de régulation pouvant être transmis par le régulateur (11) à au moins un modulateur (M₁, M₂, ..., Mₙ) par le biais d'au moins une première voie de transmission (3) et au moins un signal d'excitation pouvant être transmis depuis l'au moins un modulateur (M₁, M₂, ..., Mₙ) à chacun des étages d'attaque d'électrode d'excitation (G₁, G₂, ..., Gₙ) à chaque fois par le biais d'une deuxième voie de transmission (4), **caractérisé en ce que**
au moins un signal de régulation et/ou au moins un signal d'excitation peut être transmis au moyen d'un rayonnement électromagnétique par un émetteur (5), lequel présente une antenne pour l'émission du rayonnement électromagnétique, à un récepteur (6), lequel présente une antenne pour la réception du rayonnement électromagnétique, et dont l'au moins une voie de transmission (3, 4) associée est sans fil, **en ce que** l'au moins un signal de régulation et/ou l'au moins un signal d'excitation est modulé avec un procédé de modulation et présente au moins une fréquence porteuse dans la plage de 0,4 GHz à 400 GHz, l'au moins une voie de transmission (3, 4) associée étant sans fil.

2. Système de transmission de signal selon la revendication 1, **caractérisé en ce que** l'au moins un signal de régulation peut être transmis au moyen d'un rayonnement électromagnétique et l'au moins une première voie de transmission (3) associée est sans fil, **en ce que** le régulateur (11) comprend un émetteur (5) qui présente une antenne pour l'émission du rayonnement électromagnétique, **en ce qu'**au moins un modulateur (M₁, M₂, ..., Mₙ) comprend un récepteur (6) qui présente une antenne pour la réception du rayonnement électromagnétique et le régulateur (11) est relié avec l'émetteur (5) et **en ce que** l'au moins un modulateur (M₁, M₂, ..., Mₙ) est à chaque fois relié avec un récepteur (6).

3. Système de transmission de signal selon la revendication 1, **caractérisé en ce que** l'au moins un signal d'excitation peut être transmis au moyen d'un rayonnement électromagnétique, **en ce que** l'au moins une deuxième voie de transmission (4) associée est sans fil, **en ce qu'**au moins un modulateur (M₁, M₂, ..., Mₙ) est à chaque fois relié avec un émetteur (5) qui présente une antenne pour l'émission du rayonnement électromagnétique, **en ce qu'**au moins un étage d'attaque d'électrode d'excitation (G₁, G₂, ..., Gₙ) est à chaque fois relié avec un récepteur (6) qui présente une antenne pour la réception du rayonnement électromagnétique et une deuxième voie de transmission (4) mène à chaque fois de chaque émetteur (5) à chaque récepteur (6).

4. Système de transmission de signal selon la revendication 1, **caractérisé en ce qu'**au moins l'un des commutateurs semiconducteurs de puissance (S₁, S₂, ..., Sₙ) est à chaque fois relié avec un détecteur de surveillance (F₁, F₂, ..., Fₙ) pour mesurer à chaque fois une valeur d'état, **en ce que** l'au moins une valeur d'état peut à chaque fois être transformée en un signal de retour d'information, **en ce qu'**au moins une troisième voie de transmission (8) mène d'au moins l'un des détecteurs de surveillance (F₁, F₂, ..., Fₙ) à au moins un modulateur (M₁, M₂, ..., Mₙ) ou au régulateur (11) pour la transmission à chaque fois d'un signal de retour d'information, **en ce que** l'au moins un signal de retour d'information peut être transmis au moyen d'un rayonnement électromagnétique et l'au moins une troisième voie de transmission (8) associée est sans fil.

5. Système de transmission de signal selon la revendication 4, **caractérisé en ce que** l'au moins un détecteur de surveillance (F₁, F₂, ..., Fₙ) comprend à chaque fois un émetteur (5) qui présente une antenne pour l'émission du rayonnement électromagnétique, **en ce que** l'au moins un modulateur (M₁, M₂, ..., Mₙ) ou le régulateur (11) comprend à chaque fois un récepteur (6) qui présente une antenne pour la réception du rayonnement électromagnétique, **en ce qu'**au moins un détecteur de surveillance (F₁, F₂, ..., Fₙ) est à chaque fois relié avec un émetteur (5) et l'au moins un modulateur (M₁, M₂, ..., Mₙ) ou le régulateur (11) est relié avec l'au moins un récepteur (6).

6. Système de transmission de signal pour commander au moins un commutateur semiconducteur de puissance (S₁, S₂, ..., Sₙ) d'un circuit électronique de puissance (2) depuis un régulateur (11), chaque commutateur semiconducteur de puissance (S₁, S₂, ..., Sₙ) étant à chaque fois relié avec un étage d'attaque d'électrode d'excitation (G₁, G₂, ..., Gₙ), au moins un signal de régulation pouvant être transmis par le régulateur (11) à au moins un modulateur (M₁, M₂, ..., Mₙ) par le biais d'au moins une voie de transmission (3), au moins un signal d'excitation pouvant être transmis depuis l'au moins un modulateur (M₁, M₂, ..., Mₙ) à chacun des étages d'attaque d'électrode d'excitation (G₁, G₂, ..., Gₙ) à chaque fois par le biais d'une deuxième voie de transmission (4), au moins l'un des commutateurs semiconducteurs de puissance (S₁, S₂, ..., Sₙ) étant à chaque fois relié avec un détecteur de surveillance (F₁, F₂, ..., Fₙ) pour mesurer à chaque fois une valeur d'état, l'au moins une valeur d'état pouvant à chaque fois être transformée en un signal de retour d'information, au moins une troisième voie de transmission (8) menant d'au moins l'un des détecteurs de surveillance (F₁, F₂, ..., Fₙ) à au moins un modulateur (M₁, M₂, ..., Mₙ) ou au régulateur (11) pour la transmission à chaque fois d'un signal de retour d'information, et au moins un signal de retour d'information pouvant être transmis au moyen d'un rayonnement électromagnétique,
**caractérisé en ce que**
l'au moins un détecteur de surveillance (F₁, F₂, ..., Fₙ) comprend à chaque fois un émetteur (5) qui présente une antenne pour l'émission du rayonnement électromagnétique, **en ce qu'**au moins un modulateur (M₁, M₂, ..., Mₙ) ou le régulateur (11) comprend à chaque fois un récepteur (6) qui présente une antenne pour la réception du rayonnement électromagnétique, **en ce qu'**au moins un détecteur de surveillance (F₁, F₂, ..., Fₙ) est à chaque fois relié avec un émetteur (5), **en ce que** l'au moins un modulateur (M₁, M₂, ..., Mₙ) ou le régulateur (11) est relié avec l'au moins un récepteur (6), **en ce que** l'au moins un signal de retour d'information est modulé avec un procédé de modulation et présente au moins une fréquence porteuse dans la plage de 0,4 GHz à 400 GHz, et **en ce que** l'au moins une troisième voie de transmission (8) associée est sans fil.

7. Convertisseur statique comprenant plusieurs commutateurs semiconducteurs de puissance (S₁, S₂, ..., Sₙ), avec un système de transmission de signal selon l'une des revendications 1 à 6.
